# EUROPÄISCHE PATENTSCHRIFT

(11) **EP 3 620 800 B1**
(45) Veröffentlichungstag und Bekanntmachung des Hinweises auf die Patenterteilung: **02.11.2022**
(21) Anmeldenummer: 19194564.1
(22) Anmeldetag: 30.08.2019
(51) Int. Cl.: G01R 27/18

(54) **VERFAHREN ZUR ISOLATIONSÜBERWACHUNG EINES UMRICHTER-GESPEISTEN STROMVERSORGUNGSSYSTEMS**
METHOD FOR THE ISOLATION MONITORING OF A CONVERTER-FED POWER SUPPLY SYSTEM
PROCÉDÉ DE SURVEILLANCE DE L'ISOLATION D'UN SYSTÈME D'ALIMENTATION ÉLECTRIQUE ALIMENTÉ PAR UN CONVERTISSEUR

(30) Priorität: 10.09.2018 DE 102018121979
(43) Veröffentlichungstag der Anmeldung: 11.03.2020
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- EP-A1- 2 230 522
- WO-A1-2018/059823
- DE-A1- 10 355 086

## Beschreibung

Die vorliegende Erfindung betrifft ein Verfahren zur Bestimmung eines Isolationswiderstands eines Stromversorgungsystems, dessen aktive Teile ungeerdet sind und welches über einen mit gesteuerten Leistungshalbleiterschaltern ausgestatteten, geerdet betriebenen Stromrichter gespeist wird. An dem Ausgang des Stromrichters wird dabei eine Gleichtaktspannung gegen Erde erzeugt.

Weiterhin betrifft die Erfindung ein Verfahren zur Lokalisierung von Isolationsfehlern in einem verzweigten, ungeerdeten Stromversorgungssystem mit den Merkmalen eines Verfahrens zur Bestimmung eines Isolationswiderstands.

Mit zunehmender Automatisierung und Digitalisierung der industriellen Produktion besteht die Notwendigkeit, die von der Quelle bereitgestellte Energie zur Stromübertragung hinsichtlich der Netzform, Netzspannung und Netzfrequenz umzuformen oder an die Erfordernisse der an das Stromversorgungssystem angeschlossenen Verbraucher anzupassen. Unter einem Stromversorgungsystem, dessen aktive Teile ungeerdet sind, wird normgemäß (DIN VDE 0100-410 (VDE 0100-410):2007-06, IEC 60364-4-41:2005-12) ein Stromversorgungssystem verstanden, dessen aktive Teile gegen Erde isoliert oder über eine ausreichend hohe Impedanz mit Erde verbunden sind. Ein derartiges Stromversorgungssystem wird auch als ungeerdetes Stromversorgungssystem oder IT-System (frz. Isolé Terre) bezeichnet und weist somit eine ungeerdete Netzform auf.

Neben dem Einsatz von Wechselrichtern, welche beispielsweise die von einer Fotovoltaikanlage bereitgestellte Energie (Gleichstrom) in ein Stromversorgungssystem (Wechselstrom) einspeisen, der Verwendung von Gleichrichtern bei dem Aufbau von Gleichstromnetzen, besteht auch ein steigender Bedarf an drehzahlgeregelten elektrischen Antrieben, die mittels eines Frequenzumrichters aus dem Stromversorgungssystem gespeist werden. Im Folgenden werden unter dem Begriff Stromrichter die Realisierungen als Wechselrichter, als Gleichrichter und als Frequenzumrichter zusammengefasst.

Aufgrund der Entwicklung der Leistungselektronik hin zu immer leistungsfähiger werdenden Halbleiterschaltungen erfolgt die Umrichtung des Stromes in zunehmendem Maße elektronisch mittels Leistungshalbleiterschaltern.

Dabei weist die schaltungstechnische Realisierung des Stromrichters in der am häufigsten verwendeten Bauform, unabhängig von der Funktion als Wechselrichter, Gleichrichter oder Umrichter, prinzipiell (in Abhängigkeit der Anzahl der Phasen bei einem Wechselstrom-Stromversorgungssystem) mindestens eine Brückenschaltung aus mehreren parallelen Pfaden mit jeweils mindestens zwei Leistungshalbleiterschaltern auf. Die Leistungshalbleiterschalter werden von einem Steuerkreis mittels eines Ansteuer-Pulsmusters derart gesteuert, dass sich am Ausgang des Stromrichters das gewünschte Ausgangssignal in Form einer Wechselspannung gewünschter Frequenz oder in Form einer Gleichspannung einstellt. Stromrichter kommen in verschiedenen Netzformen zum Einsatz. Bei einer Verwendung in einem ungeerdeten Stromversorgungssystem besteht bei der normgemäß vorgeschriebenen Überwachung mit einem Isolationsüberwachungsgerät (IMD) nach IEC61557-8 die Möglichkeit, unterschiedliche Netzparameter zu ermitteln, die für den sicheren Betrieb des Stromrichters relevant sind. Insbesondere kann die in einem ungeerdeten Stromversorgungssystem vorgeschriebene kontinuierliche Überwachung des Isolationswiderstands in einem zweistelligen Megaohm-Bereich bis in den Kiloohm-Bereich hinunter zuverlässig und weitgehend unabhängig von der Größe der Netzableitkapazitäten des ungeerdeten Stromversorgungssystems erfolgen.

Mit Isolationsüberwachungsgeräten nach der Produktnorm IEC61557-8 können symmetrische und unsymmetrische Isolationsfehler erkannt werden. Die zusätzlich entstehende Brandgefahr durch symmetrische Fehler wird mit normgemäßen Isolationsüberwachungsgeräten erkannt, sodass rechtzeitig Maßnahmen getroffen werden können. Die Betrachtung des zeitlichen Verlaufs des Isolationswiderstandswertes erlaubt es, Aussagen über Feuchtigkeitseinfluss, Verschmutzung, Alterung und Degradation zu treffen. Wartungsmaßnahmen können rechtzeitig geplant und damit Anlagenstillstände vermieden werden. Man erhält somit in dem ungeerdeten Stromversorgungssystem einen Informationsvorsprung durch die kontinuierliche Isolationsüberwachung.

Aus der Offenlegungsschrift EP 2 230 522 A1 sind ein Verfahren und eine Vorrichtung zur Isolationsüberwachung eines IT-Netzes bekannt, das eine Gleichstromseite aufweist, die über einen galvanisch verbundenen Wechselrichter an eine Wechselstromseite angekoppelt ist und über einen Transformator in ein geerdetes Wechselstromnetz mündet. Zur Bestimmung des Isolationswiderstandes des IT-Netzes ist eine Widerstandsmesseinrichtung vorgesehen, die über einen Umschalter einen Referenzwiderstand wechselweise mit den Leitern der Gleichstromseite des IT-Netzes verbindet.

Die Offenlegungsschrift DE 103 55 086 A1 beschreibt ein aktives Verfahren zur Bestimmung des Isolationswiderstands in einem geerdeten Wechselstromnetz, wobei ein weitgehend rechteckförmiges Gleichtaktmessspannungssignal gegen Erde transformatorisch in das Wechselstromnetz eingespeist wird. Die Differenzstrommesssignalanteile sowie die Gleichtaktspannungssignale werden in allen Netzleitern an einer beliebigen Messstelle erfasst und zur Bestimmung des ohmschen Anteils des Isolationswiderstands ausgewertet.

Für eine Netzkonstellation, bei der ein Stromrichter, der geerdet betrieben wird, ein Stromversorgungssystem speist, dessen aktive Teile gegen Erde isoliert oder über eine ausreichend hohe Impedanz mit Erde verbunden sind, also ein geerdeter Stromrichter ein nachgeschaltetes ungeerdetes Stromversorgungssystem versorgt, gibt es nach dem Stand der Technik keine vergleichbaren, ähnlich zuverlässigen Überwachungsmöglichkeiten.

Bei dem Einsatz von geerdet betriebenen Stromrichtern ist man daher bestrebt, mit Schutzeinrichtungen, wie z. B. Leitungsschutzschaltern oder Fehlerstromschutzeinrichtungen (RCD), die gefährdende Wirkung eines Fehlerstroms auf Personen und Anlagen zeitlich zu begrenzen - es geht um schnelle Abschaltzeiten. Ein Stillstand des abgeschalteten Anlagenzweigs wird dabei akzeptiert. Um die Ausfallzeiten gering zu halten, werden sowohl Wartungspersonal als auch Ersatzbauteilkomponenten als Reserve vorgehalten.

Neben den oben genannten Schutzeinrichtungen Leitungsschutzschalter und Fehlerstromschutzeinrichtung (RCD) kommen daher in kritischen Anlagen, die nicht durchgängig ungeerdet betrieben werden, Differenzstromüberwachungssysteme (RCM) entsprechend der Produktnorm IEC62020 zum Einsatz. Ziel dieser Differenzstromüberwachung ist es, auch in geerdet betriebenen Stromrichtersystemen eine Reduzierung des Wartungsaufwands und der Stillstandzeiten zu erreichen.

Prinzipbedingt aber können bei Differenzstromüberwachungssystemen keine symmetrischen Fehler erkannt werden (Überwachungslücke). Durch die meist symmetrischen Strukturen in elektrischen Systemen sind symmetrisch fließende Fehlerströme oft ein zu erwartender Betriebszustand. Dieser kann beispielsweise durch die gleichmäßig verteilte Feuchte in Kombination mit Schmutz oder durch gleichmäßige Alterung oder Degradation der elektrischen Isolierung entstehen.

Neben dem Nachteil nicht detektierbarer symmetrischer Fehlerströme ist die Empfindlichkeit von Differenzstrom-basierten Überwachungssystemen im Gegensatz zu dem Messverhalten eines Isolationsüberwachungsgerätes in einem ungeerdeten Stromversorgungssystem deutlich abhängig von vorhandenen Netzableitkapazitäten und den durch diese bestimmten Ableitströmen.

In dem Differenzstrommesswandler des Differenzstromüberwachungssystems wird der quadratische Mittelwert aus kapazitivem Ableitstrom und ohmschem Fehlerstrom gebildet. Fließt bereits ein deutlich größerer kapazitiv bestimmter Ableitstrom, so führt ein zusätzlich entstehender gefährdender Fehlerstrom zu einer nur minimalen Erhöhung des quadratischen Mittelwertes, sodass dieser gefährdende Fehlerstrom nicht erkannt werden kann. Nach aktuellem Stand der Technik ist eine Unterscheidung zwischen kapazitiven Ableitströmen und ohmschen Fehlerströmen insbesondere in einem dreiphasigen Wechselstrom-Stromversorgungssystem rein passiv messend nicht zuverlässig möglich.

Begegnet wurde dieser drohenden Gefährdung daher mit klassischen Lösungsansätzen wie beispielsweise kurzen Wartungsintervallen, kürzeren Intervallen zwischen den Wiederholungsprüfungen, frühzeitigem Austausch kritischer Betriebsmittel, Lagerhaltung kritischer Komponenten vor Ort, um Instandsetzungszeiten bei einem Ausfall gering zu halten, Vorhalten von Bereitschaftsdiensten, um Instandsetzungszeiten bei einem Ausfall gering zu halten, statistischer Erfassung von Ausfällen und Erstellen einer Ausfallprognose bei Betrieb einer größeren Anzahl gleicher Anlagen über einen längeren Zeitraum und Aufbau von Redundanz.

Diese vorgenannten Lösungsansätze aber erweisen sich gerade im Hinblick auf immer flexibler werdende Fertigungsmethoden als zu zeit- und materialaufwändig.

Darüber hinaus ist aus der Offenlegungsschrift WO 2018/059823 A1 bekannt, zur Vermeidung eines gefährdenden Erdfehlerstroms innerhalb eines vollständig geerdeten elektrischen Antriebssystems in einem Stromrichter des Antriebssystems ein Gleichtaktspannungssignal zu erzeugen, um vorausschauend einen gefährdenden Erdfehlerstrom hoher Frequenz in dem Antriebssystem zu erkennen. Die Differenzstromerfassung beschränkt sich zum einen auf das geerdete Antriebssystem, zum anderen ist aufgrund der Differenzstrom-basierten Messung die Erkennung eines symmetrischen Fehlers nicht möglich.

Der vorliegenden Erfindung liegt somit die Aufgabe zugrunde, für ein Stromversorgungsystem, dessen aktive Teile gegen Erde isoliert oder über eine ausreichend hohe Impedanz mit Erde verbunden sind (ungeerdetes Stromversorgungssystem) und das von einem Stromrichter gespeist wird, der nicht ungeerdet betrieben wird, hinsichtlich des Isolationswiderstands vergleichbare technische Überwachungsmöglichkeiten wie in einem vollständig ungeerdeten Stromversorgungssystem zu realisieren. Insbesondere sollen symmetrische Isolationsfehler zuverlässig erkannt werden, und es soll der Einfluss der Größe der Netzableitkapazitäten auf die Bestimmung des Isolationswiderstands minimiert werden.

Diese Aufgabe wird erfindungsgemäß durch ein Varfahren nach Anspruch 1 gelöst. Vorteilhafte Ausgestaltungen finden sich in den abhängigen Ansprüchen 2-6.

Der Grundgedanke der vorliegenden Erfindung beruht nun zunächst darauf, für ein ungeerdetes Stromversorgungssystem, welches von einem geerdet betriebenen Stromrichter gespeist wird, eine aktive Messung des Isolationswiderstands zu realisieren und die zur aktiven Messung erforderliche Messspannung in dem Stromrichter zu erzeugen.

Eine üblicherweise zur Messung des Isolationswiderstands in ungeerdeten Stromversorgungssystemen verwendete Gleichtaktmessspannungsquelle, beispielsweise in Form eines Isolationsüberwachungsgerätes (IMD), ist somit nicht erforderlich, da eine in dem Stromrichter erzeugte Gleichtaktspannung gegen Erde am Ausgang des Stromrichters dem ungeerdeten Netz überlagert, d.h. jeweils zwischen aktive Leiter des Stromversorgungssystems und Erde geschaltet wird. Diese Messspannung wird zur Auswertung am Ausgang des Stromrichters an der Schnittstelle zu dem zu überwachenden Stromversorgungssystem erfasst. Durch die Verwendung der Gleichtaktspannung als aktive Messspannung können auch symmetrische Impedanzen gegen Erde, insbesondere im Fall symmetrischer Fehlerzustände, bestimmt werden. Da die Gleichtaktspannung weitgehend unabhängig von der Versorgungsspannung eingestellt werden kann, ist eine Bestimmung des Isolationswiderstands weitgehend unabhängig von den Netzableitkapazitäten, weitgehend unbeeinflusst durch Störkomponenten und unter gleichzeitiger Beachtung regulatorischer und/oder normativer Vorgaben möglich.

Die überlagerte Messspannung bewirkt einen Messstrom, der sich in einem Messkreis über die in dem Stromversorgungssystem inhärent vorhandenen Ableitimpedanzen und den geerdeten Stromrichter schließt. Bei hinreichend niedriger Frequenz des Messstroms wird dessen Größe vorrangig durch den Isolationswiderstand, also den ohmschen Anteil der Ableitimpedanz, bestimmt, da der Leitwert der Ableitkapazitäten, also des kapazitiven Anteils der Ableitimpedanz, bei niedriger Frequenz gegenüber dem ohmschen Anteil vernachlässigbar ist. Ein dem Isolationswiderstand proportionaler Messstrom wird an zentraler Stelle, bevorzugt am Ausgang des Stromrichters, erfasst, sodass in Verbindung mit der bekannten Messspannung der Isolationswiderstand bestimmt werden kann.

Die direkte Integration der Gleichtaktmessspannungserzeugung in dem Stromrichter ermöglicht somit eine kostengünstige Umsetzung mit ähnlich umfassenden Isolationsüberwachungsfunktionen, wie sie in durchgängig ungeerdeten Stromversorgungssystemen (Stromversorgungssysteme, die nicht von einem geerdet betriebenen Stromrichter gespeist werden) möglich sind.

Insbesondere erschließen sich für elektrische Anlagen, die mit einem geerdet betriebenen Stromrichter verbunden sind, mögliche Anwendungsgebiete bei kleineren, geerdet betriebenen Hausdach-PV-Anlagen; geregelten Antrieben; geerdet betriebenen Windenergieanlagen; industriellen DC-Versorgungssystemen; einer geerdet betriebenen DC-Versorgung, beispielsweise im Telekommunikations-, Rechenzentrums- oder medizinischen Bereich; geerdet betriebenen Stromrichtern für Hochofenanwendungen oder bei geerdet betriebenen Stromrichtern in Power-to-Gas-Anwendungen.

Erfindungsgemäß erfolgt das Erzeugen der Gleichtaktspannung durch Erzeugen von Pulsmustern zur Ansteuerung der Leistungshalbleiterschalter.

Um ein hinsichtlich der Signalform und Signalfrequenz gewünschtes Ausgangssignal des Stromrichters zu erzeugen, werden dessen Leistungshalbleiterschalter mit geeigneten Pulsmustern angesteuert. In der Regel werden dazu bei mehrphasigen Stromrichtern symmetrische Pulsmuster angewendet, die am Ausgang des Stromrichters zu einer zu vernachlässigenden Gleichtaktspannung führen. Durch eine Änderung der Pulsmusteransteuerung hingegen, beispielsweise durch eine Unsymmetrie der Ansteuerung, kann am Ausgang des Stromrichters eine signifikante Gleichtaktspannung gegen Erde generiert werden, die erfindungsgemäß zu Mess- und Überwachungsaufgaben in dem Stromversorgungssystem genutzt werden kann.

Vorteilhafterweise erfolgt das Erzeugen der Pulsmuster durch eine Spannungsverschiebung einer Referenzspannung für jede Phase mit einer Vorspannung.

Um am Ausgang des Stromrichters das gewünschte Gleichspannungssignal zu erzielen, werden die Pulsmuster zur Ansteuerung der Leistungshalbleiter in geeigneter Weise modifiziert. Dies geschieht durch eine Spannungsverschiebung einer Referenzspannung für jede Phase mit einer Vorspannung.

In weiterer Ausgestaltung des Verfahrens wird die Vorspannung derart eingestellt, dass diese eine Rechteck-Kurvenform mit einer Grundfrequenz unterhalb einer Netzfrequenz des Stromversorgungssystems aufweist, sodass sich eine Messfrequenz der Messspannung in Höhe der Grundfrequenz der Vorspannung ergibt.

Einstellbare Parameter der Vorspannung sind vornehmlich die Amplitude, die Frequenz und die Kurvenform der Vorspannung, wobei sich diese Parameter auf Parameter der gewünschten Gleichtaktspannung abbilden. Insbesondere spiegeln sich die Kurvenform und die Frequenz der Vorspannung in der Kurvenform und der Frequenz der Gleichtaktspannung wider und bilden damit eine zur Bestimmung des Isolationswiderstands geeignete Messspannung, die vorteilhafterweise an die Systemparameter, wie die Größe der Ableitkapazitäten, des zu überwachenden Stromversorgungssystems angepasst werden kann.

Bei großen vorhandenen Netzableitkapazitäten, wie beispielsweise in weit verzweigten, ungeerdeten Stromversorgungssystemen, ist es daher von Vorteil, eine Frequenz der Vorspannung und damit eine gleiche sich ergebende Frequenz der Gleichtaktspannung, also der Messspannung, zu wählen, die deutlich unterhalb der Netzfrequenz des ungeerdeten Stromversorgungssystems liegt. Zudem kann bei der Verwendung einer Rechteck-Kurvenform auf bekannte Algorithmen zur Signalverarbeitung in Isolationsüberwachungsgeräten für ungeerdete Stromversorgungssysteme zurückgegriffen werden.

Neben der Anpassung der einstellbaren Parameter der Vorspannung unter Berücksichtigung der vorhandenen Netzableitkapazitäten kann auch eine Optimierung dieser Parameter unter Beachtung möglicher Störsignaleinflüsse erfolgen.

Das Verfahren kann vorteilhaft in elektrischen Anlagen Anwendung finden, in denen der Stromrichter als Wechselrichter oder als Gleichrichter oder als Frequenzumrichter ausgeführt ist.

Das erfindungsgemäße Verfahren, insbesondere das Erzeugen der Pulsmuster zur Ansteuerung der Leistungshalbleiterschalter, ist daher unabhängig davon, in welcher Funktion der Stromrichter eingesetzt wird. Das Verfahren ist also anwendbar, wenn beispielsweise ein an den Stromrichter in Funktion eines Gleichrichters angeschlossenes DC-Stromversorgungssystem zu überwachen ist oder falls hinter dem als Wechselrichter oder als Frequenzumrichter arbeitenden Stromrichter ein AC-Stromversorgungssystem betrieben wird.

Mögliche Anwendungsfälle des erfindungsgemäßen Verfahrens sind somit beispielsweise: Fotovoltaikanlagen, die auf der Einspeiseseite des Fotovoltaikwechselrichters geerdet betrieben werden; industriell eingesetzte, gleichrichtergespeiste DC-Versorgungen mit einer geerdeten Netzform auf der AC-Seite; Frequenzumrichterantriebe mit einer geerdeten Netzform auf der eingangsseitigen AC-Seite; gleichrichtergespeiste DC-Versorgungen von Rechenzentren mit einer geerdeten Netzform auf der AC-Seite; gleichrichterbasierte, unterbrechungsfreie Stromversorgungen (USV) mit einer geerdeten Netzform auf der AC-Seite; Wechselrichterantriebe von Elektrofahrzeugen mit einer galvanischen Verbindung der Antriebsseite zur Fahrzeugkarosserie.

Basierend auf dem erfindungsgemäßen Verfahren zur Bestimmung des Isolationswiderstands wird die Aufgabe der Überwachung in einem verzweigten Stromversorgungssystem weiterhin durch ein Verfahren zur Lokalisierung von Isolationsfehlern mit folgenden weiteren Verfahrensschritten gelöst: Erfassen eines durch die Messspannung bewirkten Fehlerstroms in einem zu überwachenden Anlagenzweig des ungeerdeten Stromversorgungssystems mittels einer Differenzstrommesseinrichtung und Bewerten des Fehlerstroms zur Erkennung eines mit einem Isolationsfehler behafteten Anlagenzweigs.

Das erfindungsgemäße Verfahren zur Bestimmung des Isolationswiderstands kann durch Erfassen eines durch die Messspannung bewirkten Fehlerstroms in einem zu überwachenden Anlagenzweig des ungeerdeten Stromversorgungssystems mittels einer Differenzstrommessung zu einem Verfahren erweitert werden, welches zur Lokalisierung von Isolationsfehlern und damit zur Lokalisierung fehlerbehafteter Anlagenzweige dient.

Dazu wird in aus dem Stand der Technik bekannter Weise in jedem zu überwachenden Anlagenzweig eine Differenzstrommesseinrichtung installiert, die einen von der Gleichtaktspannung als Messspannung getriebenen Fehlerstrom in einem von einem Isolationsfehler betroffenen Anlagenzweig erkennt.

Die in dem Stromrichter erzeugte Gleichtaktspannung in der Funktion als Messspannung (Prüfspannung) ersetzt einen aufwändig zu installierenden Prüfstrom-Generator, wie er üblicherweise in Isolationsfehler-Sucheinrichtungen Verwendung findet.

Mit Vorteil erfolgt ein Bestimmen einer Teilnetzableitkapazität des zu überwachenden Anlagenzweiges.

Auf der Grundlage der in dem zu überwachenden Anlagenzweig erfassten Messspannung und des durch die Messspannung bewirkten Fehlerstroms kann die (Teil-)Netzableitkapazität des zu überwachenden Anlagenzweiges bestimmt werden.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern. Es zeigen:
- **Fig. 1:**: eine Prinzipdarstellung der Überwachungslücke "symmetrischer Fehler" bei passiver Differenzstrommesstechnik,
- **Fig. 2:**: eine Prinzipdarstellung des Einflusses kapazitiver Ableitströme auf die Messempfindlichkeit bei Fehlerstrommessungen,
- **Fig. 3:**: Simulation eines Stromrichters (Wechselrichter mit STC-Modulation) mit Spannungsverschiebung zur Erzeugung einer Gleichtaktspannung,
- **Fig. 4a:**: Simulationsergebnisse (Signalverläufe) der Stromrichtersimulation aus Fig. 3 ohne Spannungsverschiebung,
- **Fig. 4b:**: Simulationsergebnisse (Signalverläufe) der Stromrichtersimulation aus Fig. 3 mit Spannungsverschiebung,
- **Fig. 5a:**: eine erfindungsgemäße Isolationsüberwachung eines ungeerdeten DC-Stromversorgungssystems,
- **Fig. 5b:**: eine erfindungsgemäße Isolationsüberwachung eines ungeerdeten AC-Stromversorgungssystems,
- **Fig. 6a:**: eine erfindungsgemäße Lokalisierung von Isolationsfehlern in einem verzweigten, ungeerdeten DC-Stromversorgungssystem, und
- **Fig. 6b:**: eine erfindungsgemäße Lokalisierung von Isolationsfehlern in einem verzweigten, ungeerdeten AC-Stromversorgungssystem.

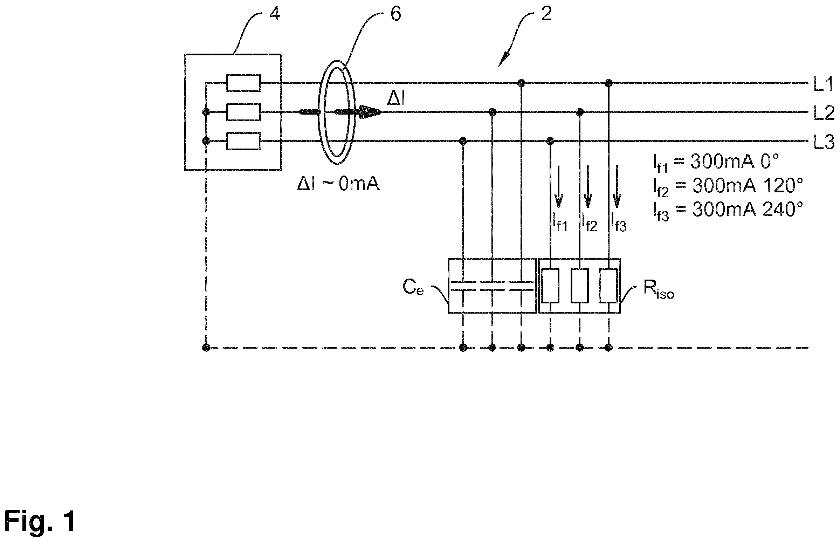

In **Fig. 1** ist in einer Prinzipdarstellung die Überwachungslücke "symmetrischer Fehler" dargestellt, die bei Verwendung von passiver Differenzstrommesstechnik auftreten kann. Gezeigt ist ein Stromversorgungssystem 2 mit aktiven Leitern (Phasenleitern, Phasen) L1, L2 und L3, welches über eine Stromquelle 4 geerdet ist. Eine Differenzstrommesseinrichtung 6 erfasst die vektorielle Summe der in den Leitern L1, L2 und L3 fließenden Ströme. Die Differenzstrommesseinrichtung 6 kann dabei Teil einer Fehlerstrom-Schutzeinrichtung (RCD) oder einer Fehlerstrom-Überwachungseinrichtung (RCM) sein.

Aufgrund der meist symmetrischen Strukturen in elektrischen Systemen kann bei einer Isolationsverschlechterung oftmals von einem symmetrischen Fehlerfall ausgegangen werden, d. h. von einem Isolationsfehler, der auf alle drei Leiter L1, L2 und L3 in gleicher Weise einwirkt. In Fig. 1 wird dieser Isolationsfehler durch den Isolationswiderstand Rᵢₛₒ - im Fehlerfall auch durch R_{f} (Isolationsfehler oder Isolationsfehlerwiderstand) - dargestellt, der zwischen den Leitern L1, L2, L3 (einschließlich der aller daran angeschlossenen Betriebsmittel) und Erde wirksam wird und zusammen mi der Ableitkapazität Cₑ die komplexwertige Ableitimpedanz des gesamten Stromversorgungssystems 2 als konzentriertes Element modelliert.

Wegen der symmetrischen Phasenlage ist die vektorielle Summe der in den Leitern L1, L2 und L3 über den Isolationswiderstand Rᵢₛₒ fließenden Fehlerströme I_{f1}, I_{f2} und I_{f3} und damit der sich ergebende Differenzstrom ΔI annähernd Null.

Trotz erheblicher Größe der Fehlerströme I_{f1}, I_{f2} und I_{f3} können diese nicht erkannt werden und führen bei der Verwendung passiver Differenzstrommesstechnik in Verbindung mit dem Auftreten von symmetrischen Fehlern zu einer Überwachungslücke.

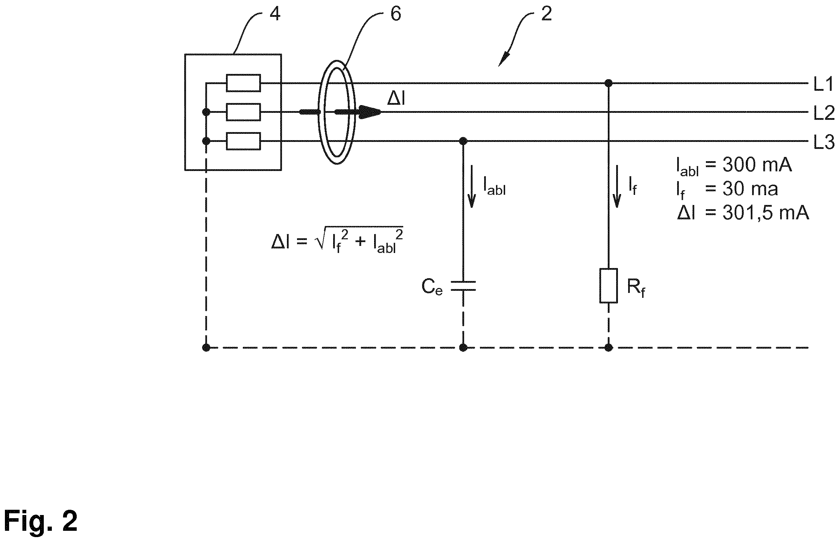

In **Fig. 2** ist in einer Prinzipdarstellung der Einfluss kapazitiver Ableitströme auf die Messempfindlichkeit bei Fehlerstrommessungen aufgezeigt.

Ein Nachteil, der bei der Verwendung von Differenzstrom-basierten Überwachungssystemen im Vergleich zu dem Einsatz von normgemäß installierten Isolationsüberwachungsgeräten (IMD) auftritt, ist, dass das Messverhalten Differenzstrom-basierter Überwachungssysteme deutlich abhängig von vorhandenen Netzableitkapazitäten und den durch diese bestimmten Ableitströmen ist. Fließt bereits ein erheblicher kapazitiver Ableitstrom I_{ab1}, so ergibt sich aufgrund der vektoriellen Addition mit einem kleineren, aber dennoch gefährlichen Fehlerstrom I_{f} nur eine geringe Zunahme des Differenzstroms, der bei einer unzureichenden Empfindlichkeit der Differenzstrommesseinrichtung nicht zuverlässig erkannt werden kann. Das Zahlenbeispiel in Fig. 2 verdeutlicht eine nur geringfügige Erhöhung des Differenzstroms ΔI von 1.5mA, wenn zusätzlich zu dem inhärent vorhandenen Ableitstrom I_{ab1} ein Fehlerstrom I_{f} von 30mA auftritt (Nutzströme seien hier außer Acht gelassen).

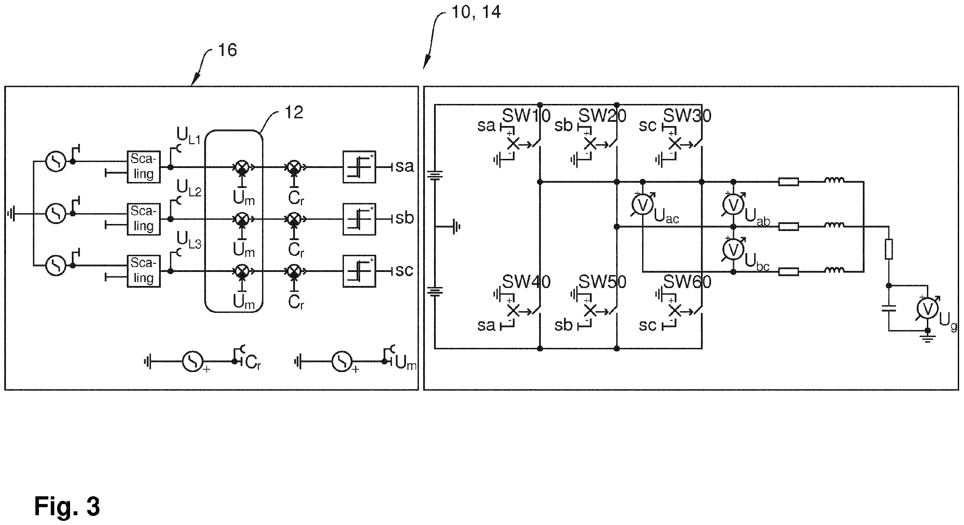

In **Fig. 3** ist ein Simulationsmodell eines Stromrichters 10 mit Spannungsverschiebung 12 zur Erzeugung einer Gleichtaktspannung als Messspannung U_{g} dargestellt.

In dem Simulationsmodell ist der Stromrichter 10 als Wechselrichter 14 modelliert, dessen Leistungshalbleiterschalter SW10 bis SW60 von einem Steuerkreis 16 mittels Pulsmuster sa, sb, sc angesteuert werden. In dem Modell wird beispielhaft das Erzeugen der Pulsmuster sa, sb, sc zur Ansteuerung der Leistungshalbleiterschalter SW10 bis SW60 mit dem STC-Modulationsverfahren (Sinus-Dreieck-Vergleich im Center Aligned Mode - Sinus Triangle Comparison) gezeigt. Die nachfolgend erläuterte Modifikation der Ansteuerpulsmuster sa, sb, sc zur Erzeugung einer optimierten Messspannung U_{g} ist auch mit anderen bekannten Modulationsverfahren (STC-THI, CSVM, DSVM type A, DSVM type B, DSVM type C) möglich.

Prinzipiell werden bei dem hier beschriebenen STC-Verfahren in bekannter Weise die Ansteuerpulsmuster sa, sb, sc durch Modulation eines höherfrequenten, dreieckförmigen Trägersignals Cᵣ mit normierten Sinus-Referenzspannungen U_{L1}, U_{L2}, U_{L3} derart moduliert, dass sich möglichst sinusförmige Ausgangsspannungen U_{ab}, U_{ac}, U_{bc} ergeben.

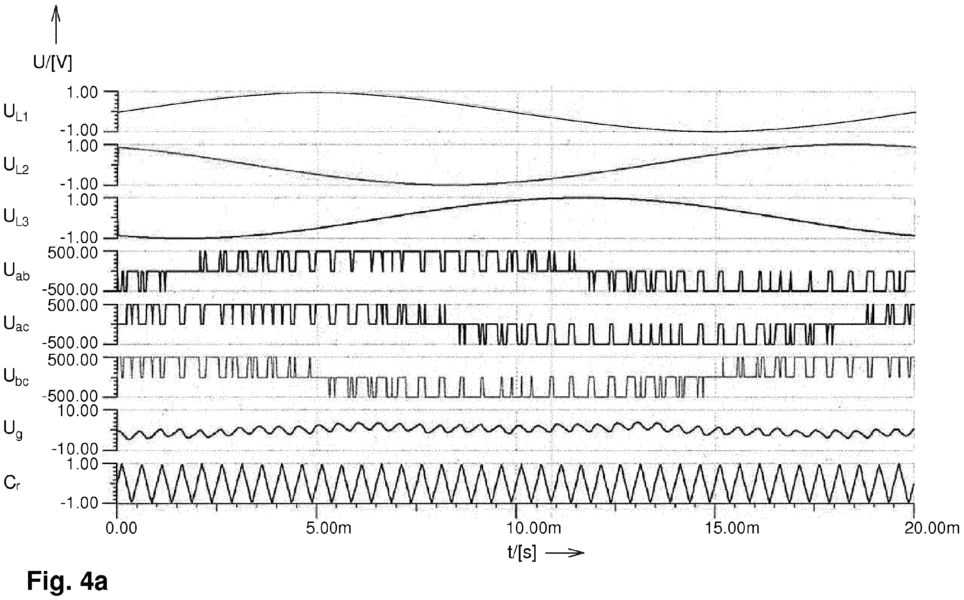

Ohne die Spannungsverschiebung 12, d. h. bei symmetrischer Ansteuerung des Trägersignals Cᵣ, würde sich an dem Ausgang des Wechselrichters keine signifikante Gleichtaktspannung als Messspannung U_{g} einstellen (siehe den Signalverlauf der Messspannung U_{g} in Fig. 4a).

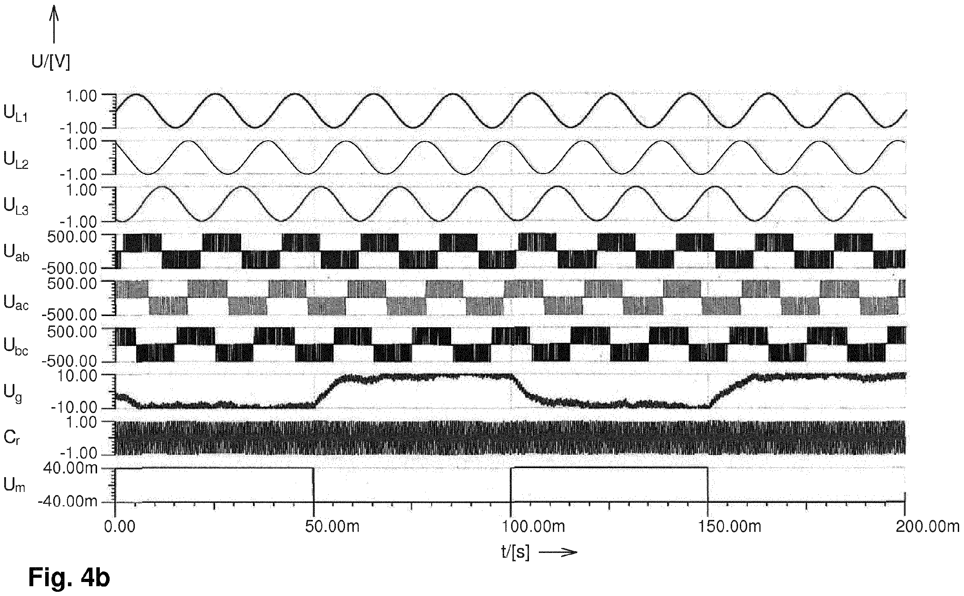

Wird die Ansteuerpulsmustererzeugung in dem Steuerkreis 16 allerdings durch die Spannungsverschiebung 12 dahingehend modifiziert, dass für jede Phase L1, L2, L3 der jeweiligen Sinus-Referenzspannung U_{L1}, U_{L2}, U_{L3} eine Vorspannung Uₘ überlagert wird, ergibt sich am Ausgang des Wechselrichters 14 eine messbare und als Messspannung U_{g} verwertbare Gleichtaktspannung gegen Erde (siehe Signalverlauf der Messspannung U_{g} in Fig. 4b).

In **Fig. 4a** sind zunächst die Signalverläufe aufgezeichnet, die sich als Simulationsergebnisse aus der Stromrichtersimulation nach Fig. 3 ohne Spannungsverschiebung 12 ergeben.

Zur Veranschaulichung der grundsätzlichen Wirkungsweise eines Wechselrichterbetriebs sind die drei um jeweils 120 ° gegeneinander verschobenen Sinus-Referenzspannungen U_{L1}, U_{L2} und U_{L3} mit einer Frequenz von 50Hz dargestellt, die jeweils das höherfrequente (2kHz), dreieckförmige Trägersignal Cᵣ modulieren. Die resultierenden Ausgangsspannungen U_{ab}, U_{ac} und U_{bc} weisen als Überlagerung der Mittelanzapfungen der Brückenzweige des Wechselrichters 14 zwar weitgehend rechteckförmige Impulse auf, enthalten jedoch als gewünschte Grundschwingung die Frequenz der Sinus-Referenzspannungen U_{L1}, U_{L2} und U_{L3}.

Die sich einstellende Gleichtaktspannung (Messspannung U_{g}) beträgt nur wenige 100 Millivolt und ist als Messspannung U_{g} zur Isolationsüberwachung oder zur Lokalisierung von Isolationsfehlern in Stromversorgungsnetzen nicht oder nur sehr eingeschränkt nutzbar.

Die **Fig. 4b** zeigt die Signalverläufe als Simulationsergebnisse der Stromrichtersimulation aus Fig. 3 mit Spannungsverschiebung 12.

Durch die Spannungsverschiebung 12 wird den jeweiligen Sinus-Referenzspannungen U_{L1}, U_{L2} und U_{L3} jeweils eine Vorspannung Uₘ mit einer rechteckförmigen Kurvenform und einer Amplitude von + 40mV sowie einer Grundfrequenz von 10Hz überlagert.

Im Ergebnis stellt sich als Messspannung U_{g} eine Gleichtaktspannung gegen Erde ein, die eine Amplitude von + 10V und ebenfalls eine Grundfrequenz von 10Hz aufweist (zu beachten ist der gegenüber Fig. 4a komprimierte Zeitmaßstab). Mit dieser Messsignalfrequenz von 10Hz deutlich unterhalb der Netzfrequenz von 50Hz eignet sich die so erzeugte Messspannung U_{g} für eine Bestimmung des Isolationswiderstands auch bei vorhandenen großen Netzableitkapazitäten, da die kapazitiven Ableitströme I_{ab1} (Fig. 2) weitgehend abgeklungen sind und das Messergebnis nicht verfälschen.

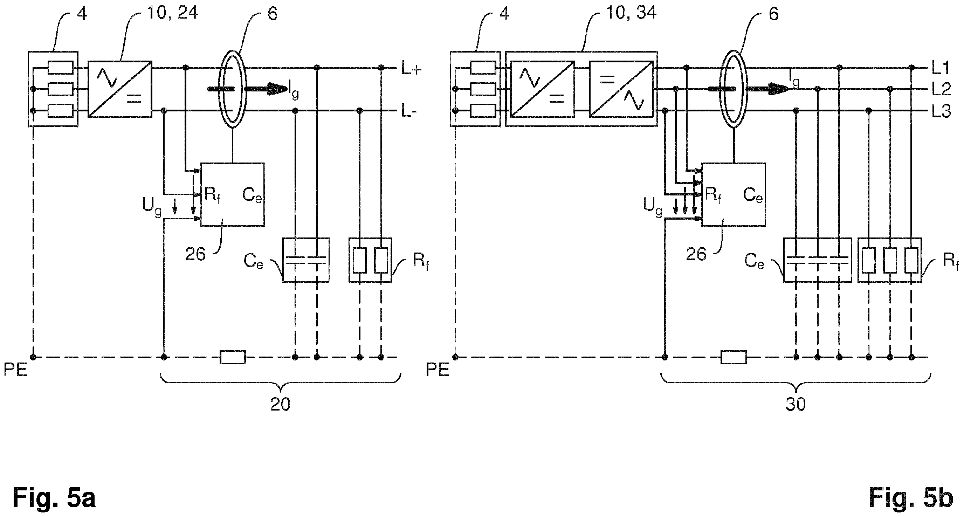

Die **Fig. 5a** und **5b** zeigen Anwendungen der erfindungsgemäßen Isolationsüberwachung für ein ungeerdetes DC-Stromversorgungssystem (Fig. 5a) und für ein ungeerdetes AC-Stromversorgungssystem (Fig. 5b).

**Fig. 5a** zeigt einen als Gleichrichter 24 ausgeführten Stromrichter 10, der über eine Stromquelle 4 geerdet betrieben wird. An den Gleichrichter 24 ist ausgangsseitig ein ungeerdetes DC-Stromversorgungssystem mit den aktiven Leitern L+ und L- angeschlossen. Die Ableitkapazitäten Cₑ und die Isolationswiderstände R_{f} des ungeerdeten Stromversorgungssystems 20 sind als konzentrierte Elemente gegen Erde PE (Schutzleiter PE) dargestellt.

Eine Überwachungseinrichtung 26 misst die von dem Gleichrichter 24 erfindungsgemäß bereitgestellte Messspannung U_{g} einerseits und empfängt andererseits den Wert eines von der Messspannung U_{g} bewirkten Messstroms ((Gleichtakt-)Fehlerstrom) I_{g}, welcher von einer Differenzstrommesseinrichtung 6 auf den aktiven Leitern L+ und L- als Summenstrom erfasst wird. Aus diesen beiden Größen wird der Isolationswiderstand R_{f} berechnet.

Durch Modifikation der Ansteuerpulsmuster sa, sb, sc in dem gesteuerten Gleichrichter 24 (Fig. 3) kann die Messspannung U_{g} so an das ungeerdete Stromversorgungssystem 20 angepasst werden, dass - im Gegensatz zu einer Differenzstrom-basierten Erfassung ohne angepasstes Messsignal nach Fig. 2 - die Ableitkapazitäten Cₑ und die damit verbundenen Ableitströme I_{ab1} keinen wesentlichen verfälschenden Einfluss auf das Messergebnis haben.

Damit stellt das erfindungsgemäße Verfahren zur Bestimmung des Isolationswiderstands R_{f} die gleiche Funktionalität mit der gleichen Zuverlässigkeit wie ein normgemäßes Isolationsüberwachungsgerät (IMD) zur Verfügung, mit dem Vorteil, dass auf eine externe, aufwändig zu installierende Gleichtaktmessspannungsquelle verzichtet werden kann.

Darüber hinaus ist es möglich, in der Überwachungsvorrichtung 26 neben dem Isolationswiderstand R_{f} auch die Größe der Ableitkapazität Cₑ zu bestimmen.

**Fig. 5b** zeigt einen Anwendungsfall, in dem der Stromrichter 10 als Frequenzumrichter 34 ausgeführt ist, der über eine Stromquelle 4 geerdet betrieben wird. An den Ausgang des Frequenzumrichters 34 ist ein AC-Stromversorgungssystem 30 angeschlossen. Auch hier erfolgt die Bestimmung des Isolationswiderstands R_{f} und ggf. der Ableitkapazität Cₑ in einer Überwachungseinrichtung 26, welche die von dem Frequenzumrichter erzeugte Messspannung U_{g} und den von dieser Messspannung U_{g} bewirkten Messstrom I_{g} auswertet.

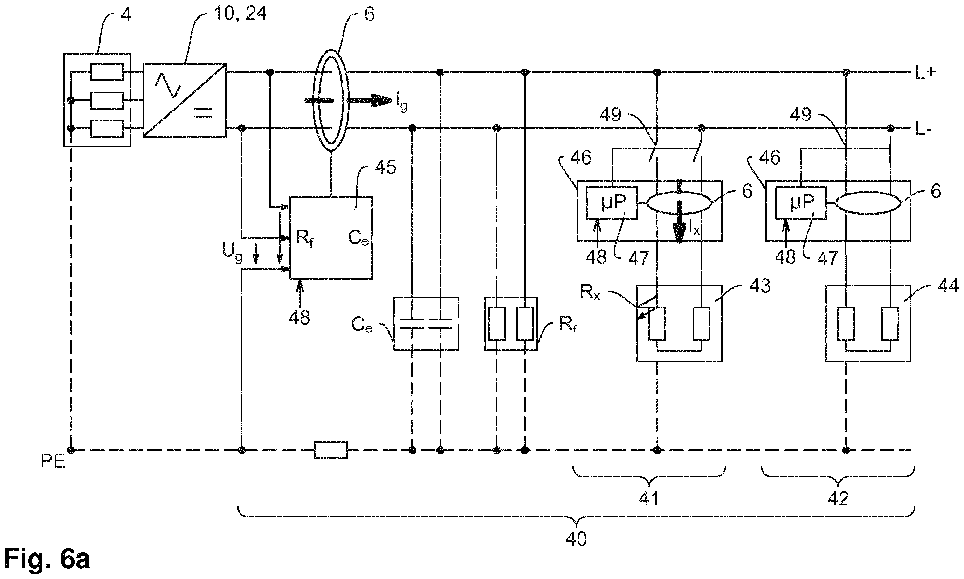

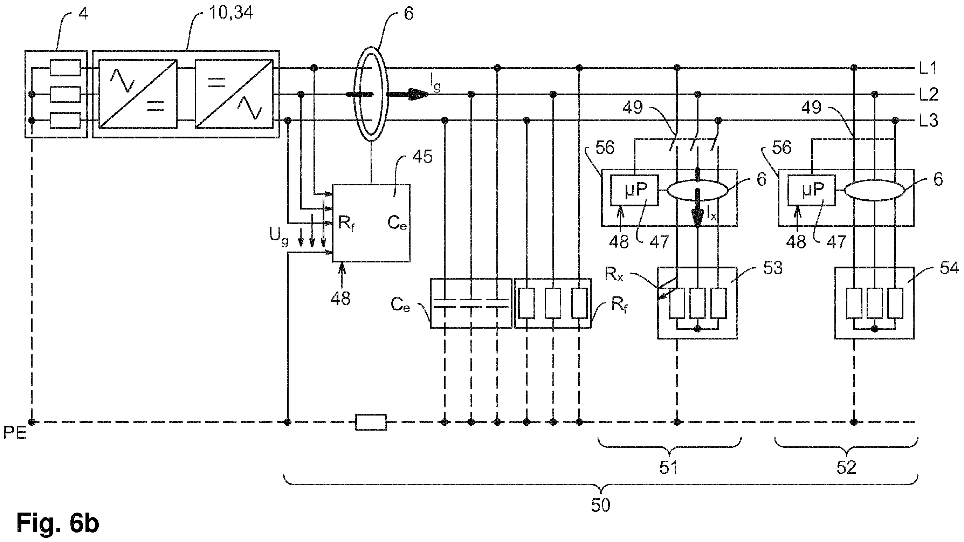

Die **Fig. 6a** und **6b** zeigen eine erfindungsgemäße Lokalisierung von Isolationsfehlern in einem von dem geerdet betriebenen Gleichrichter 24 gespeisten, verzweigten, ungeerdeten DC-Stromversorgungssystem (Fig. 6a) sowie in einem von dem geerdet betriebenen Frequenzumrichter 34 gespeisten, verzweigten, ungeerdeten AC-Stromversorgungssystem (Fig. 6b).

Das verzweigte, ungeerdete DC-Stromversorgungssystem 40 in Fig. 6a weist zwei Anlagenzweige 41, 42 auf, an die jeweils ein Verbraucher 43, 44 angeschlossen ist und die jeweils über eine Trennvorrichtung 49 von dem Hauptsystem abgetrennt werden können.

Die Anlagenzweige 41, 42 wie auch die Anlagenzweige 51, 52 in Fig. 6b weisen analog zu dem Hauptsystem - so wie jedes Stromversorgungssystem - inhärent vorhandene, nicht dargestellte (Teil-)Isolationswiderstände und (Teil-)Netzableitkapazitäten auf.

Tritt in einem Anlagenzweig 41 ein Isolationsfehler Rₓ auf, beispielsweise wie dargestellt durch eine fehlerhafte Isolierung an einem Verbraucher 43, so entsteht ein geschlossener Strompfad, der sich über den Isolationsfehler Rₓ und den geerdet betriebenen Gleichrichter 24 schließt und in dem ein Fehlerstrom Iₓ fließt.

In den Anlagenzweigen 41, 42 ist jeweils eine Auswerteeinrichtung 46 angeordnet. Die Auswerteeinrichtungen 46 weisen jeweils eine Differenzstrommesseinrichtung 6 zur zweigselektiven Erfassung des (möglichen) Fehlerstroms Iₓ auf, der als Gleichtaktstrom von der in dem Gleichrichter 24 erzeugten Messspannung U_{g} (Gleichtaktspannung) getrieben wird. Die Auswerteeinrichtungen 46 umfassen weiterhin jeweils einen Mikroprozessor 47 und jeweils eine Schnittstelle 48 zur Übertragung des erfassten Fehlerstroms Iₓ.

Eine erweiterte Überwachungseinrichtung 45 weist zusätzlich eine (Empfangs-)Schnittstelle 48 zum Empfang des von den Auswerteeinrichtungen 46 übermittelten Fehlerstroms Iₓ auf.

Anhand der in dem Hauptsystem und in den Anlagenzweigen 41, 42 installierten Differenzstrommesseinrichtungen 6 kann der von dem Fehlerstrom Iₓ gebildete Strompfad nachvollzogen und somit der fehlerbehaftete Anlagenzweig 41 erkannt werden.

Im fehlerfreien Fall des Stromversorgungssystems können aus der von der erweiterten Überwachungseinrichtung 45 gemessenen Messspannung U_{g} und von den Auswerteeinrichtungen 46 an die erweiterte Überwachungseinrichtung 45 übermittelten, in den jeweiligen überwachten Anlagenzweige 41, 42 fließenden (Gleichtakt-)Messströmen der (Teil-)Isolationswiderstand und/oder die (Teil-)Netzableitkapazität des jeweiligen überwachten Anlagenzweiges 41, 42 in der erweiterten Überwachungseinrichtung 45 berechnet werden.

Die Auswerteergebnisse können lokal gespeichert werden, lokal angezeigt werden oder an eine übergeordnete Leitstelle weitergegeben werden, um entsprechende Sicherheitsmaßnahmen zu veranlassen.

Alternativ dazu kann auch die Ermittlung des (Teil-)Isolationswiderstandswertes des zu überwachenden Anlagenzweiges 41, 42 und optional auch dessen (Teil-)Netzableitkapazität in der jeweiligen Auswerteeinrichtung 46 direkt erfolgen. In diesem Fall verteilt die erweiterte Überwachungseinrichtung 45 die Information über die Messspannung U_{g} an die Auswerteeinrichtungen 46, um die zweigselektive Ermittlung in der jeweiligen Auswerteeinrichtung 46 "vor Ort" zu ermöglichen.

Als kritisch bewertete Anlagenzweige 41, 42 können über den jeweiligen Mikroprozessor 47 und die Trennvorrichtungen 49 abgeschaltet werden.

Die Darstellung in der **Fig. 6b** entspricht hinsichtlich des Aufbaus und der Funktionsweise prinzipiell der Darstellung in der Fig. 6a mit dem Unterschied, dass anstelle des verzweigten, ungeerdeten DC-Stromversorgungssystems 40 ein verzweigtes, ungeerdetes AC-Stromversorgungssystem 50 mit zwei Anlagenzweigen 51, 52 mit dem Ausgang eines geerdet betriebenen Frequenzumrichters 34 verbunden ist. An die Anlagenzweige 51, 52 sind mehrphasige Verbraucher 53, 54 angeschlossen, wobei der Isolationsfehler Rₓ in einem Verbraucher 51 aufgetreten ist.

Jeder Anlagenzweig 51, 52 weist eine Auswerteeinrichtung 56 mit einem Mikroprozessor 47 und eine Differenzstrommesseinrichtung 6 sowie eine über den Mikroprozessor 47 gesteuerte dreiphasige Trennvorrichtung 59 auf.

## Patentansprüche

1. Verfahren zur Bestimmung eines Isolationswiderstands (R_{f}) eines Stromversorgungssystems (20, 30, 40, 50), dessen aktive Teile ungeerdet sind, und welches über einen mit gesteuerten Leistungshalbleiterschaltern (SW10, SW20, SW30, SW40, SW50, SW60) ausgestatteten, geerdet betriebenen Stromrichter (10, 14, 24, 34) gespeist wird, umfassend die Verfahrensschritte:
- Erzeugen einer Gleichtaktspannung gegen Erde am Ausgang des Stromrichters (10, 14, 24, 34), wobei das Erzeugen der Gleichtaktspannung durch Erzeugen von Pulsmustern (sa, sb, sc) zur Ansteuerung der Leistungshalbleiterschalter (SW10, SW20, SW30, SW40, SW50, SW60) erfolgt,
- Überlagern der Gleichtaktspannung als Messspannung (U_{g}) zur Bestimmung des Isolationswiderstands (R_{f}) des ungeerdeten Stromversorgungssystems (20, 30, 40, 50),
- Erfassen der Messspannung (U_{g}) in dem ungeerdeten Stromversorgungssystem (20, 30, 40, 50),
- Erfassen eines Messstroms (I_{g}), der aufgrund der Messspannung (U_{g}) in dem ungeerdeten Stromversorgungssystem (20, 30, 40, 50) über den Isolationswiderstand (R_{f}) fließt,
- Bestimmen des Isolationswiderstands (R_{f}) durch Bewertung des Messstroms (I_{g}).

2. Verfahren nach Anspruch 1,
**dadurch gekennzeichnet,**
**dass** das Erzeugen der Pulsmuster (sa, sb, sc) durch eine Spannungsverschiebung (12) einer Referenzspannung (U_{L1}, U_{L2}, U_{L3}) für jede Phase (L1, L2, L3) des Stromrichters (10, 14, 24, 34) mit einer Vorspannung (Uₘ) erfolgt.

3. Verfahren nach Anspruch 2,
**dadurch gekennzeichnet,**
**dass** die Vorspannung (Uₘ) derart eingestellt wird, dass diese eine Rechteck-Kurvenform mit einer Grundfrequenz unterhalb einer Netzfrequenz des Stromversorgungssystems (20, 30, 40, 50) aufweist, sodass sich eine Messfrequenz der Messspannung (U_{g}) in Höhe der Grundfrequenz der Vorspannung (Uₘ) ergibt.

4. Verfahren nach einem der Ansprüche 1 bis 3,
**gekennzeichnet durch**
eine Anwendung, in der der Stromrichter (10, 14, 24, 34) als Wechselrichter (14) oder als Gleichrichter (24) oder als Frequenzumrichter (34) ausgeführt ist.

5. Verfahren zur Lokalisierung von Isolationsfehlern in einem verzweigten Stromversorgungssystem (40, 50), dessen aktive Teile ungeerdet sind, und welches über einen mit gesteuerten Leistungshalbleiterschaltern (SW10, SW20, SW30, SW40, SW50, SW60) ausgestatteten, geerdet betriebenen Stromrichter (10, 14, 24, 34) gespeist wird, mit den Merkmalen eines Verfahrens zur Bestimmung eines Isolationswiderstands (R_{f}) nach einem der Ansprüche 1 bis 4, umfassend die weiteren Verfahrensschritte:
- Erfassen eines durch die Messspannung (U_{g}) bewirkten Fehlerstroms (Iₓ) in einem zu überwachenden Anlagenzweig (41, 42, 51, 52) des ungeerdeten Stromversorgungssystems (40, 50) mittels einer Differenzstrom-Messeinrichtung (6),
- Bewerten des Fehlerstroms (Iₓ) zur Erkennung eines mit einem Isolationsfehler (Rₓ) behafteten Anlagenzweigs (41, 51).

6. Verfahren nach Anspruch 5,
**gekennzeichnet durch**
Bestimmen eines Teil-Isolationswiderstands und/oder einer TeilNetzableitkapazität des zu überwachenden Anlagenzweigs (41, 42, 51, 52).

## Claims

1. A method for determining an insulation resistance (R_{f}) of a power supply system (20, 30, 40, 50) whose active parts are ungrounded and which is supplied via a converter (10, 14, 24, 34) operated to ground and equipped with controlled power semiconductor switches (SW10, SW20, SW30, SW40, SW50, SW60), the method comprising the following steps:
- generating a common-mode voltage to ground at the output of the converter (10, 14, 24, 34), the common-mode voltage being generated by generating pulse patterns (sa, sb, sc) for controlling the power semiconductor switches (SW10, SW20, SW30, SW40, SW50, SW60),
- superimposing the common-mode voltage as a measuring voltage (U_{g}) for determining the insulation resistance (R_{f}) of the ungrounded power supply system (20, 30, 40, 50),
- detecting the measuring voltage (U_{g}) in the ungrounded power supply system (20, 30, 40, 50),
- detecting a measuring current (I_{g}) which flows in the ungrounded power supply system (20, 30, 40, 50) via the insulation resistance (R_{f}) because of the measuring voltage (U_{g}),
- determining the insulation resistance (R_{f}) by assessing the measuring current (I_{g}).

2. The method according to claim 1,
**characterized in that**
the pulse patterns (sa, sb, sc) are generated by a voltage displacement (12) of a reference voltage (U_{L1}, U_{L2}, U_{L3}) for each phase (L1, L2, L3) of the converter (10, 14, 24, 34) using a bias voltage (Uₘ).

3. The method according to claim 2,
**characterized in that**
the bias voltage (Uₘ) is set in such a manner that it has a square waveform with a fundamental frequency below a network frequency of the power supply system (20, 30, 40, 50), resulting in a measuring frequency of the measuring voltage (U_{g}) at the level of the fundamental frequency of the bias voltage (Uₘ).

4. The method according to any one of claims 1 to 3,
**characterized by**
an application in which the converter (10, 14, 24, 34) is configured as an inverter (14) or as a rectifier (24) or as a frequency converter (34).

5. A method for locating insulation faults in a branched power supply system (40, 50) whose active parts are ungrounded and which is supplied via a converter (10, 14, 24, 34) operated to ground and equipped with controlled power semiconductor switches (SW10, SW20, SW30, SW40, SW50, SW60), the method comprising the features of a method for determining an insulation resistance (R_{f}) according to any one of claims 1 to 4, the method further comprising the steps of:
- detecting a residual current (Iₓ) caused by the measuring voltage (U_{g}) in a system branch (41, 42, 51, 52) to be monitored in the ungrounded power supply system (40, 50) by means of a residual current measuring device (6),
- assessing the residual current (Iₓ) to detect a system branch (41, 51) exhibiting an insulation fault (Rₓ).

6. The method according to claim 5,
**characterized by**
determining a partial insulation resistance and/or a partial network leakage capacitance of the system branch (41, 42, 51, 52) to be monitored.

## Revendications

1. Procédé pour déterminer une résistance d'isolement (R_{f}) d'un système (20, 30, 40, 50) d'alimentation électrique dont parts actifs ne sont pas mis à la terre et qui est alimenté par un convertisseur de puissance (10, 14, 24, 34) opéré à la terre et équipé d'interrupteurs (SW10, SW20, SW30, SW40, SW50, SW60) à semi-conducteur électroniques commandés de puissance, le procédé comprenant les étapes suivantes :
- générer une tension en mode commun à la terre à la sortie du convertisseur de puissance (10, 14, 24, 34), la tension en mode commun étant générée en générant des formes d'impulsion (sa, sb, sc) pour commander les interrupteurs (SW10, SW20, SW30, SW40, SW50, SW60) de puissance à semi-conducteur électroniques,
- interférant la tension en mode commun comme tension de mesure (U_{g}) pour déterminer la résistance d'isolement (R_{f}) du système (20, 30, 40, 50) d'alimentation électrique non mis à la terre,
- détecter la tension de mesure (U_{g}) dans le système (20, 30, 40, 50) d'alimentation électrique non mis à la terre,
- détecter un courant de mesure (I_{g}) qui s'écoule dans le système (20, 30, 40, 50) d'alimentation électrique non mis à la terre par la résistance d'isolement (R_{f}) à cause de la tension de mesure (U_{g}),
- déterminer la résistance d'isolement (R_{f}) en évaluant le courant de mesure (I_{g}).

2. Procédé selon la revendication 1,
**caractérisé en ce que**
les formes d'impulsion (sa, sb, sc) sont générées par un déplacement (12) d'une tension de référence (U_{L1}, U_{L2}, U_{L3}) pour chaque phase (L1, L2, L3) du convertisseur de puissance (10, 14, 24, 34) en utilisant une tension de polarisation (Uₘ).

3. Procédé selon la revendication 2,
**caractérisé en ce que**
la tension de polarisation (Uₘ) est ajustée de telle manière qu'elle est en forme rectangulaire ayant une fréquence fondamentale au-dessous d'une fréquence de réseau du système (20, 30, 40, 50) d'alimentation électrique, ça résultant en une fréquence de mesure de la tension de mesure (U_{g}) au niveau de la fréquence fondamentale de la tension de polarisation (Uₘ).

4. Procédé selon l'une quelconque des revendications 1 à 3,
**caractérisé par**
une utilisation dans laquelle le convertisseur de puissance (10, 14, 24, 34) est conçue comme onduleur (14) ou comme redresseur (24) ou comme convertisseur de fréquence (34).

5. Procédé pour localiser des défauts d'isolement dans un système (40, 50) d'alimentation électrique arborescent dont parts actifs ne sont pas mis à la terre et qui sont alimentés par un convertisseur de puissance (10, 14, 24, 34) opéré à la terre et équipé d'interrupteurs (SW10, SW20, SW30, SW40, SW50, SW60) à semi-conducteur électroniques commandés de puissance, le procédé comprenant les propriétés d'un procédé pour déterminer une résistance d'isolement (R_{f}) selon l'une quelconque des revendications 1 à 4, le procédé comprenant les autres étapes :
- détecter un courant de défaut (Iₓ) produit par la tension de mesure (U_{g}) dans une branche de système (41, 42, 51, 52) à être surveillée dans le système (40, 50) d'alimentation électrique non mis à la terre au moyen d'un dispositif (6) de mesure de courant de différence,
- évaluer le courant de défaut (Iₓ) pour détecter une branche de système (41, 51) montrant un défaut d'isolement (Rₓ).

6. Procédé selon la revendication 5,
**caractérisé par**
la détermination d'une résistance d'isolement partielle et/ou une capacité de fuite de réseau partielle de la branche de système (41, 42, 51, 52) à être surveillée.
